(19) Europäisches Patentamt

**European Patent Office**

Office européen des brevets

(11) Numéro de publication: **0 083 528**
**A1**

(12) **DEMANDE DE BREVET EUROPEEN**

(21) Numéro de dépôt: 82402347.7

(22) Date de dépôt: **21.12.82**

(51) Int. Cl.³: **H 03 K 17/96**

(30) Priorité: **31.12.81 FR 8124565**

(43) Date de publication de la demande: **13.07.83**
**Bulletin 83/28**

(84) Etats contractants désignés: **BE DE GB IT NL**

(71) Demandeur: **THOMSON-CSF, 173, Boulevard Haussmann, F-75379 Paris Cedex 08 (FR)**

(72) Inventeur: **Micheron, François, THOMSON-CSF SCPI 173, bld Haussmann, F-75379 Paris Cedex 08 (FR)**
Inventeur: **Ravinet, Pierre, THOMSON-CSF SCPI 173, bld Haussmann, F-75379 Paris Cedex 08 (FR)**

(74) Mandataire: **Wang, Pierre et al, THOMSON-CSF SCPI 173, Bld Haussmann, F-75379 Paris Cedex 08 (FR)**

(54) **Générateurs piézoélectriques d'impulsions électriques.**

㉗ L'invention se rapporte à des générateurs piézoélectriques d'impulsions électriques.

L'invention a pour objet d'associer un transducteur piézoélectrique (11) à un élément non linéaire (12) pour délivrer des impulsions à un circuit d'utilisation (13).

L'invention s'applique notamment à des dispositifs dans lesquels une pression exercée engendre un signal électrique. Elle peut être utilisée dans des claviers à touches.

## GENERATEURS PIEZOELECTRIQUES D'IMPULSIONS ELECTRIQUES

L'invention se rapporte aux systèmes d'introduction de données mettant en oeuvre la frappe d'un clavier muni de touches. Parmi l'art antérieur, on peut relever des systèmes à contact où l'enfoncement d'une touche provoque la fermeture d'un circuit électrique, et des systèmes sans contact générateurs de signaux électriques. Parmi ces derniers systèmes on connaît des générateurs électro-mécaniques ou des transducteurs photo-électriques. L'inconvénient majeur de ces systèmes est qu'ils nécessitent des sources locales d'énergie pour fonctionner. Il est alors préférable d'utiliser des systèmes auto-générateurs où l'énergie fournie par la frappe des touches est convertie en énergie électrique. Ces systèmes auto-générateurs sont basés sur l'utilisation de polymères ou de tout autre matériau piézoélectrique.

Il est connu que dans les interrupteurs appelés à effectuer un très grand nombre de cycles ouverture-fermeture, comme dans le cas des claviers, le principal problème vient du contact lui-même qui tend à se dégrader et pour lequel il est nécessaire d'utiliser des métaux nobles tels que l'or. Rappelons que des claviers téléphoniques par exemple doivent effectuer au moins 500 000 opérations sans défauts. Par ailleurs, les informations fournies par les claviers tendent de plus en plus à être traitées par des circuits logiques. De ce fait, fournir une impulsion électrique lors de l'appui sur une touche ou fermer temporairement un circuit contenant un générateur de tension sont deux opérations équivalentes vues du circuit de traitement du signal. L'avantage de la touche active tient à ce qu'elle ne comporte pas de contacts fragiles. De plus, lorsqu'un contact ou un déclenchement doit être prévu dans un système de sécurité, il est connu que la fiabilité d'un dispositif auto-générateur est supérieur à celle d'un dispositif commutateur passif. Une difficulté rencontrée avec les dispositifs auto-générateurs réside dans le fait que la loi d'enfoncement d'une touche peut influencer les caractéristiques du signal électrique délivré, ce qui peut conduire à une interprétation erronée des données introduites.

En vue de pallier cet inconvénient, la présente invention vise l'association à des touches de type piézoélectrique d'un circuit électrique de mise en forme producteur d'impulsions.

Plus précisément, l'invention a pour objet un générateur d'impulsions électriques à commande mécanique comprenant au moins un transducteur piézoélectrique muni d'une paire d'électrodes, caractérisé en ce qu'il comprend au moins un élément de commutation entrant en conduction à partir d'un seuil et possédant une plage de conduction s'étendant en deçà dudit seuil ; un circuit électrique d'utilisation formant avec ledit élément et ledit transducteur un circuit à décharge brusque produisant l'une desdites impulsions lors d'un dépassement dudit seuil.

L'invention sera mieux comprise au moyen de la description ci-après et des figures annexées parmi lesquelles :

- la figure 1 représente une poutre encastrée formée d'un matériau piézoélectrique,

- les figures 2 à 4 sont des schémas explicatifs,

- la figure 5 représente le schéma d'un générateur d'impulsions,

- la figure 6 est une caractéristique courant-tension,

- les figures 7 à 9 sont des diagrammes explicatifs,

- les figures 10 et 11 sont des schémas de générateurs d'impulsions,

- les figures 12 et 13 représentent des aspects d'un transducteur piézoélectrique,

- la figure 14 est une caractéristique courant-tension,

- la figure 15 est un schéma d'un générateur d'impulsions,

- la figure 16 est un diagramme explicatif,

- les figures 17 et 18 sont des schémas de générateurs d'impulsions,

- la figure 19 est un diagramme explicatif,

- les figures 20 et 21 représentent des aspects d'un transducteur piézoélectrique,

- la figure 22 est le schéma électrique d'un clavier à touches,

- les figures 23 et 24 sont des vues partielles d'un clavier à touches,

- la figure 25 est le schéma électrique d'un générateur de tensions alternatives.

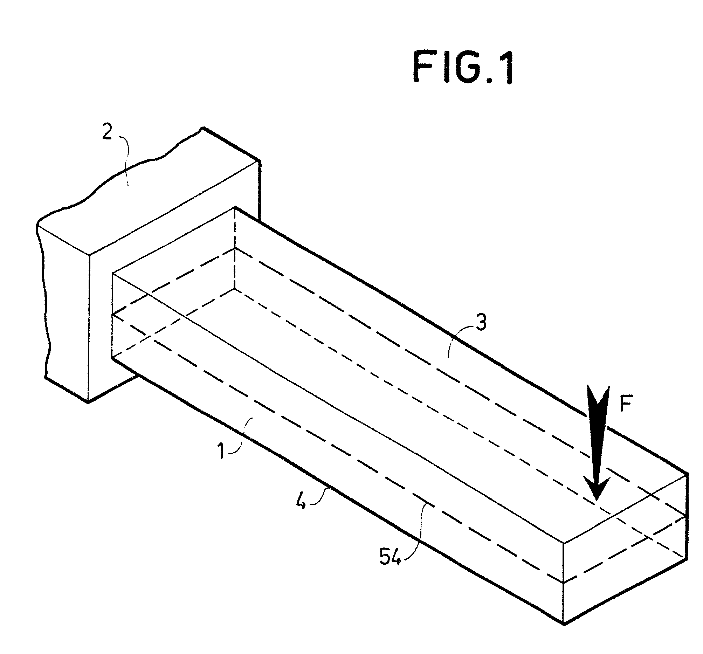

Avant d'aborder l'étude du générateur d'impulsions électrique selon l'invention, il est utile de décrire le comportement d'une poutre constituée par un matériau piézoélectrique et encastrée à une extrémité. La figure 1 représente un tel assemblage. La poutre 1 est encastrée dans une partie fixe 2 . Cette poutre fonctionnant en flexion est nécessairement du type bimorphe. La ligne neutre 54 est représentée en traits interrompus. La poutre est du type bimorphe à polarisations rémanentes de signes opposés dans les deux feuillets qui la contituent et qui sont situés de part et d'autre de la ligne neutre 54. Une force F s'exerçant à l'extrémité libre de la poutre provoque entre les faces opposées 3 et 4 une différence de potentiel due aux charges électriques liées engendrées par la déformation de la poutre et par la polarisation électrique du matériau qui la constitue.

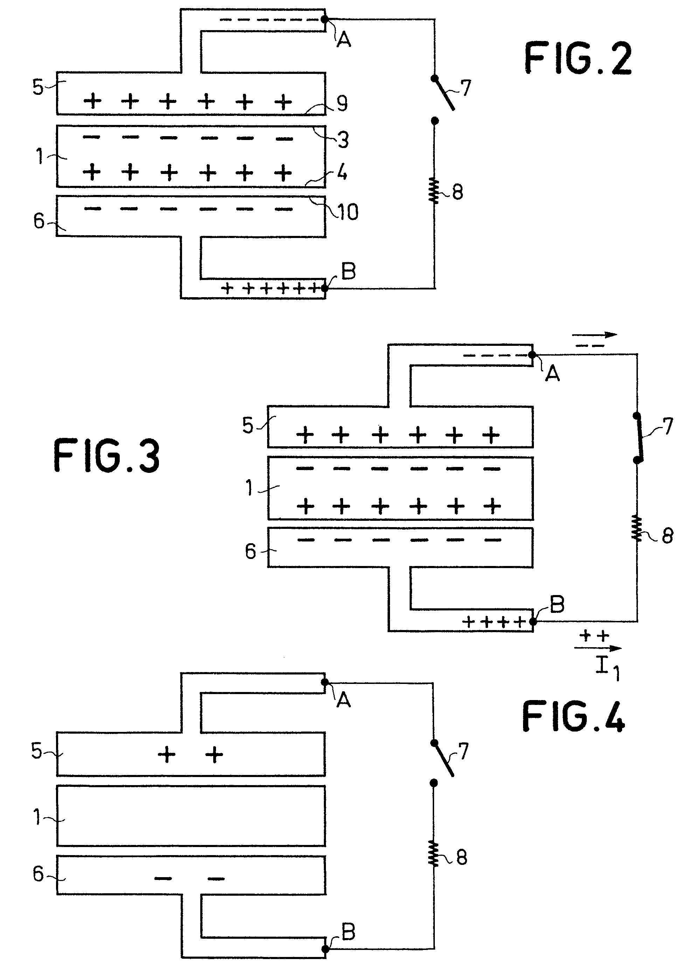

En déposant des électrodes 5 et 6, comme le montre la figure 2, respectivement sur les faces 3 et 4 de la poutre on dispose ainsi d'un générateur capacitif de tension par conversion de l'énergie mécanique en énergie électrique. Le circuit électrique peut se fermer par l'intermédiaire de l'interrupteur 7 sur une résistance 8. On appellera $V_{AB}$ la tension disponible pratiquement entre les électrodes. Sur la figure 2 on voit que le circuit est ouvert, la poutre a été fléchie faisant alors apparaître des charges liées sur les surfaces 3 et 4 de la poutre. Par influence, il se crée sur les surfaces 9 et 10 des électrodes 5 et 6 un déplacement de charges par influence qui contrebalancent les charges superficielles de la poutre. Le déplacement de charges sur la face 9 de l'électrode 5 provoque un refoulement de charges libres vers la partie A de cette électrode. Le bilan global des charges dans l'électrode 5 est nul tant que le circuit reste ouvert. Le même phénomène d'influence se passe pour l'électrode 6 avec des charges de signes opposées.

La figure 3 représente le circuit de la figure 2 lorsque l'interrupteur 7 est fermé. La flexion de la poutre n'a pas été modifiée donc le nombre de charges liées apparaissant sur les faces 3 et 4 de la poutre, 9 et 10 des électrodes n'est pas modifié. A l'instant où l'on ferme l'interrupteur 7, on peut considérer que des charges libres venant de l'extrémité A se recombinent avec des charges venant de l'extrémité B, créant ainsi un courant $I_1$ de décharge traversant la résitance 8. Si on ouvre l'interrupteur 7 avant la recombinaison totale des charges libres venant des extrémités A et B, la neutralité électrique des électrodes est rompue.

Au stade représenté par la figure 4, on a supposé que la poutre est revenue à sa position initiale et le circuit est ouvert. Les charges liées de la poutre apparues précédemment par effet piézoélectrique ont disparu, les charges de signes opposés de chaque électrode se sont recombinées dans la mesure où elles trouvaient une charge de signe opposé. On conçoit qu'il apparaît alors des déficits de charges libres qui n'ont pu se recombiner et qui sont de signes opposés pour chaque électrode. En fermant à nouveau l'interrupteur 7 ces déficits de charges libres peuvent se combler en créant un courant $I_2$ de décharge dans la résistance 8 qui sera de signe opposé au courant $I_1$. La résistance 8 a donc été parcourue successivement par 2 impulsions de signes opposés.

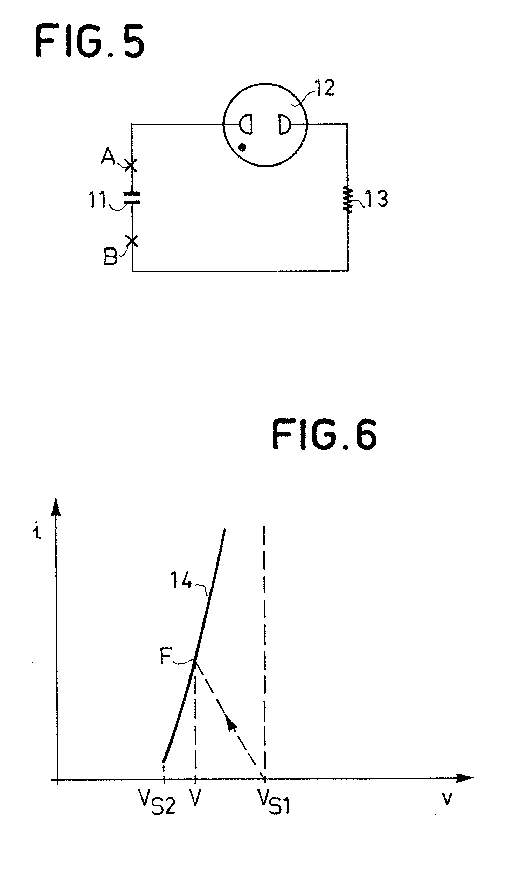

La figure 5 est un schéma électrique d'un générateur piézoélectrique d'impulsions selon l'invention. Il comprend un transducteur piézoélectrique 11, un élément de commutation 12 et une charge résistive 13 branchés en série. Il est avantageux d"employer un transducteur utilisant un matériau piézoélectrique polymère en bimorphe, fonctionnant en flexion. Ce peut être le polyfluorure de vinylidène ($PVF_2$). On peut également employer un autre matériau organique, par exemple un copolymère, ou un minéral ayant des propriétés piézoélectriques tel que les céramiques de type PZT (constituées d'oxydes de plomb, de zirconium et de titane) et fabriquées par la compagnie Clevite Brush. On peut également utiliser parmi les piézoélectriques poly-cristallins une couche mince d'oxyde de zinc ZnO sur un support. Il est avantageux d'utiliser un transducteur ayant la forme d'une poutre encastrée à une extrémité afin d'obtenir un bon rendement énergétique. C'est sur l'extrémité libre que l'on fera porter la force d'enfoncement. Comme on l'a vu précédemment le transducteur peut être assimilé à un condensateur chargé. C'est d'ailleurs sous cette forme que l'on a représenté le transducteur de la figure 5.

L'élément de commutation 12 est un dispositif non linéaire dont la caractéristique courant-tension doit être telle que sous l'effet de la déformation subie par le bilame piézoélectrique la tension monte librement aux bornes du transducteur, l'élément 12 n'étant pas conducteur, jusqu'à une tension de seuil $V_{s1}$ à partir de laquelle il conduit. L'état de conduction correspond à une plage de tension située en deçà du seuil d'allumage $V_{S1}$ ; cette plage à pour limite inférieure une autre tension de seuil $V_{S2}$ en deçà de laquelle l'élément retourne à l'état non conducteur. L'hystérésis résultant de la différenciation des seuils est nécessaire pour qu'une quantité de charges soit brusquement transférée au circuit d'utilisation. La figure 6 est un diagramme représentant la caractéristique courant-tension de l'élément 12 dans le cas où celui-ci est un tube à décharge gazeuse tel qu'un tube à néon.

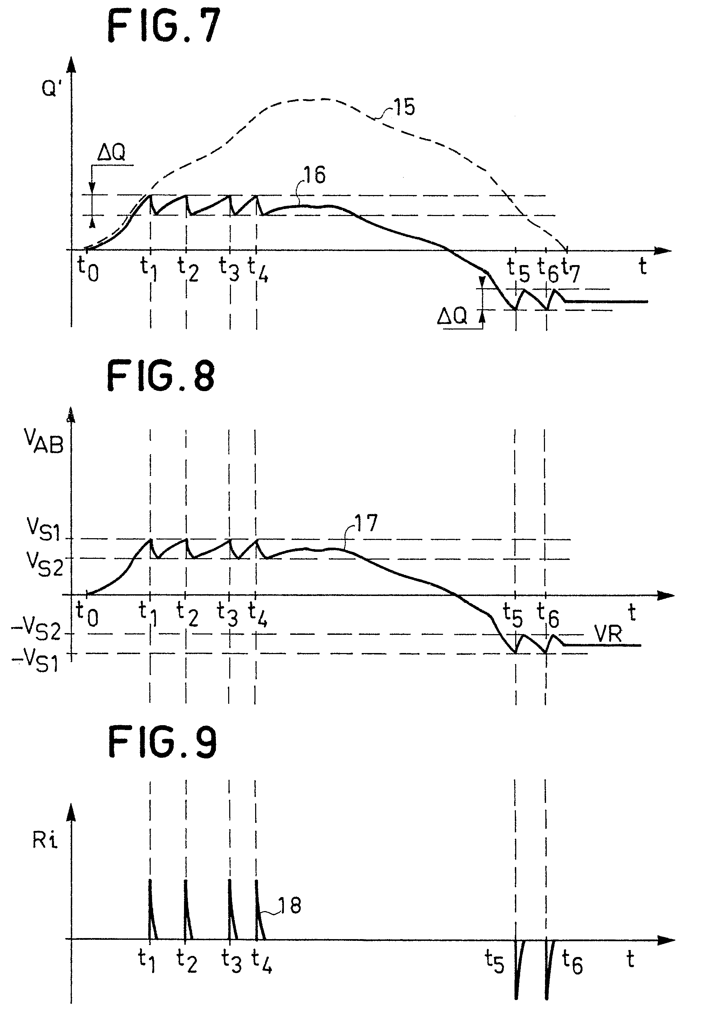

Un ordre de grandeur de la tension de seuil d'allumage $V_{S1}$ est par exemple 80 V et la distance entre ce seuil et la plage de maintien est $V_{S1}$-$V_{S2}$ = 20 V environ. Au moment où le transducteur est soumis à une déformation, une tension à vide apparaît entre ses électrodes. Cette tension est proportionnelle à la déformation de l'élément activé et croît tant que l'effort de déformation continue et que le seuil de conduction $V_{S1}$ n'est pas atteint ce qui est représenté sur la figure 6 par un cheminement selon une droite confondue avec l'axe des tensions. Lorsque la tension générée aux bornes du transducteur atteint la valeur $V_{S1}$, une décharge brusque se produit dans le néon et celui-ci devient conducteur. A ce stade, le point de fonctionnement F du circuit pour la caractéristique i = f(V) représentée à la figure 6 se trouve sur la droite 14 avec une tension V aux bornes de l'élément 12 inférieure à $V_{S1}$ et supérieure ou égale au seuil d'extinction $V_{S2}$. Bien que l'effort de déformation du transducteur continue à être appliqué la tension aux bornes de l'élément 12 décroît du fait de la chute de tension aux bornes de la résistance 13. Le point de fonctionnement F se déplace alors rapidement vers le bas de la caractéristique 14 et la tension aux bornes de la lampe néon finit par atteindre la valeur $V_{S2}$ pour laquelle le courant de conduction cesse. Une partie Δ Q des charges libres induites sur les électrodes a été transvasée par le courant de décharge. Pourvu que le temps de déformation soit plus long que la constante de temps RC, où R est la résistance de charge et C la capacité du transducteur, le dispositif peut produire une série de décharges impulsionnelles calibrées comme le montrent les figures 7 à 10.

La figure 7 représente en fonction du temps la charge résiduelle Q' représentée par la courbe 16, qui peut être fournie au circuit de décharge au fur et à mesure de son fonctionnement. Pour une force appliquée à l'extrémité libre du transducteur, celui-ci subit une déformation engendrant par effet piézoélectrique l'apparition de charges liées qui se reportent par influence sur les électrodes 5 et 6 du transducteur. La force de déformation est considérée être appliquée pendant une durée s'étendant de $t_o$ à $t_7$. En circuit ouvert le nombre de charges refoulées vers les extrémités A et B des électrodes correspond au nombre des charges liées internes au transducteur et est proportionnel à la force appliquée. C'est ce que représentent la courbe 15 et les parties de la courbe 16 entre deux décharges successives.

La courbe 17 de la figure 8 montre l'allure de la tension $V_{AB}$ entre les électrodes A et B du transducteur. De $t_o$ à $t_1$, le circuit est ouvert et la tension $V_{AB}$ est proportionnelle à la charge induite par la déformation. A partir de $t_1$ l'élément non linéaire 12 devient conducteur puisque la tension $V_{AB}$ a atteint la valeur $V_{S1}$. A ce moment une quantité de charges $\Delta Q$ s'écoule à travers le circuit et il se produit un déséquilibre entre le nombre des charges liées internes au transducteur et les charges disponibles aux extrémités A et B des électrodes. C'est ce qui indique la divergence des courbes 15 et 16 de la figure 7. Lorsque la tension aux bornes de l'élément 12 tombe à la valeur $V_{S2}$, celui-ci devient non conducteur et la capacité C est à nouveau en circuit ouvert. Ensuite elle se recharge d'une valeur $\Delta Q$ pour permettre à nouveau la conduction de l'élément 12 à l'instant $t_2$. Il s'ensuit une série de charges et de décharges comme l'indiquent les figures 7 et 8. Pendant la recharge de la capacité C les courbes 15 et 16 suivent des évolutions concordantes.

A partir de la décharge postérieure à $t_4$, la force exercée sur le transducteur se relachant, les conditions sont réunies pour qu'il se produise une inversion de tension aux extrémités A et B des électrodes. Lorsque $V_{AB} = - V_{S1}$ l'élément 12 devient à nouveau conducteur et une décharge inverse a lieu jusqu'au moment où $V_{AB} = - V_{S2}$. La figure 9 montre en fonction du temps les impulsions 18 recueillies aux bornes du circuit d'utilisation 13. Dans le cas où ce circuit est une résistance électrique R, on obtient une tension R.i comme indiquée sur la figure 9, où i est le courant traversant le circuit 13. La durée et l'amplitude des impulsions 18 sont fonctions de la capacité du transducteur, de la résistance totale : $R + \rho$ , $\rho$ étant la résistance de l'élément 12 à l'état conducteur et du saut de tension $V_{S1} - V_{S2}$.

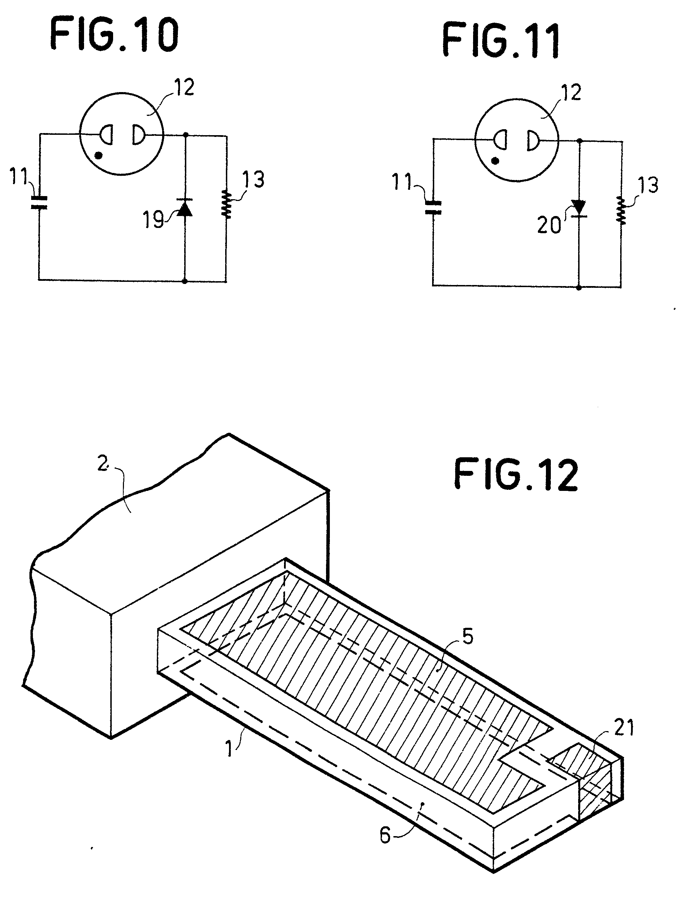

La caractéristique remarquable du tube à néon est sa conductivité quasiment nulle à l'état non allumé pour autant que les connexions du tube soient correctement isolées. Cette particularité permet d'utiliser des capacités piézoélectriques de très faibles valeurs (quelques p F). Il faut ajouter en faveur du tube à néon que son prix est raisonnable et que sa fiabilité de fonctionnement est parfaitement éprouvée. Son fonctionnement indifférent à la polarité de la tension peut constituer un autre avantage auquel on peut renoncer en montant en parallèle une diode. Le choix de la polarité de l'impulsion engendrée peut également être fait à l'aide de diodes montées en parallèle sur le circuit d'utilisation 13. La figure 10 est un circuit où les impulsions négatives sur le circuit d'utilisation 13 sont supprimées par la présence de la diode 19 qui les court-circuite. Le circuit de la figure 11 par contre privilège les impulsions négatives à l'aide de la diode 20. Comme indiqué précédemment, il est également possible d'éliminer les impulsions positives ou négatives en plaçant une diode en parallèle sur l'élément non linéaire. Le sens de conduction de la diode détermine le choix des impulsions recueillies sur la charge. Le tube à néon assure un transfert partiel de la charge libérée puisque le seuil d'extinction $V_{S2}$ n'est pas nul. De ce fait après une première action sur le transducteur, il subsiste une tension résiduelle $V_R$ entre les électrodes A et B, comme l'indique la figure 8. Cette tension $V_R$ est susceptible de rendre le fonctionnement du circuit dépendant de ses états antérieurs. En effet une seconde action sur le transducteur devra tenir compte des charges ou tension résiduelles et pourra très bien ne déclencher aucune impulsion. Il convient donc de remettre le système à zéro en court-circuitant la tension résiduelle au retour du transducteur à l'état de repos mécanique.

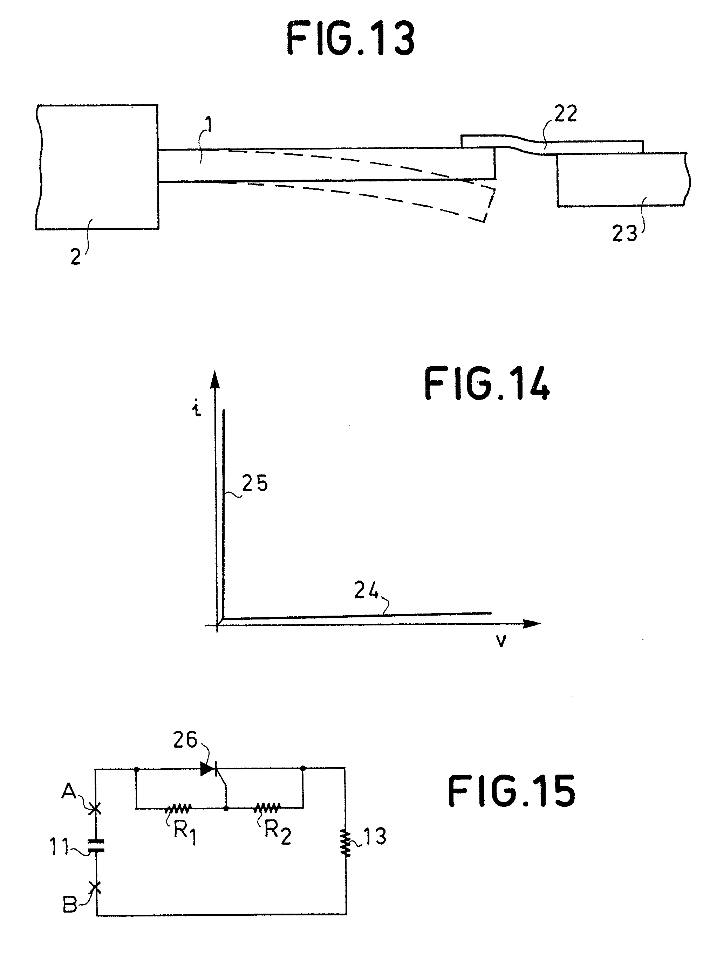

La figure 12 représente un transducteur du type utilisé dans l'invention muni de ses électrodes 5 et 6. Une languette conductrice 21 rattachée à l'électrode 6 est rabattue sur la face où se trouve l'électrode 5 dans une découpe de cette électrode. Il est alors aisé de prévoir un élément qui réunira les deux électrodes au même potentiel lorsque le transducteur reviendra à sa position initiale. Un exemple de réalisation est donné à la figure 13 où les deux électrodes du transducteur sont court-circuitées par l'élément conducteur 22 lorsque le transducteur est revenu à l'état de repos.

On a représenté en trait interrompu le transducteur déformé. L'élément 22 doit être suffisamment souple pour ne pas exercer une contrainte mécanique sur le transducteur au repos. Il ne doit pas non plus être trop souple pour éviter qu'il ne se déplace avec le transducteur lors d'une manoeuvre de celui-ci. Il doit avoir une résistance suffisante pour ne pas réaliser un court-circuit franc entre les électrodes qui peuvent présenter une différence de potentiel de plusieurs dizaines de volt. L'élément 22 peut avantageusement être réalisé par une languette de caoutchouc conducteur collée sur un socle fixe 23.

L'inconvénient de la présence de la tension résiduelle $V_R$ dans le circuit précédent peut être évité par l'utilisation d'éléments non linéaires à semi-conducteurs tels que thyristors et triacs qui ont une tension d'extinction pratiquement nulle. Le thyristor est un dispositif bistable qui peut être commuté de l'état bloqué à l'état passant. Son amorçage dépend du courant de gâchette. La figure 14, qui est une caractéristique courant-tension, montre les deux états de fonctionnement d'un thyristor. Tant que l'amorçage du thyristor n'a pas lieu, le courant i traversant le thyristor soumis à une tension v n'est qu'un courant de fuite. La courbe 24 est représentative de cet état de non conduction. Par contre lorsque le thyristor est déclenché celui-ci devient bon conducteur pour une faible chute de tension à ses bornes comme l'indique la courbe 25. Le point de fonctionnement passe alors brusquement de la courbe 24 à la courbe 25.

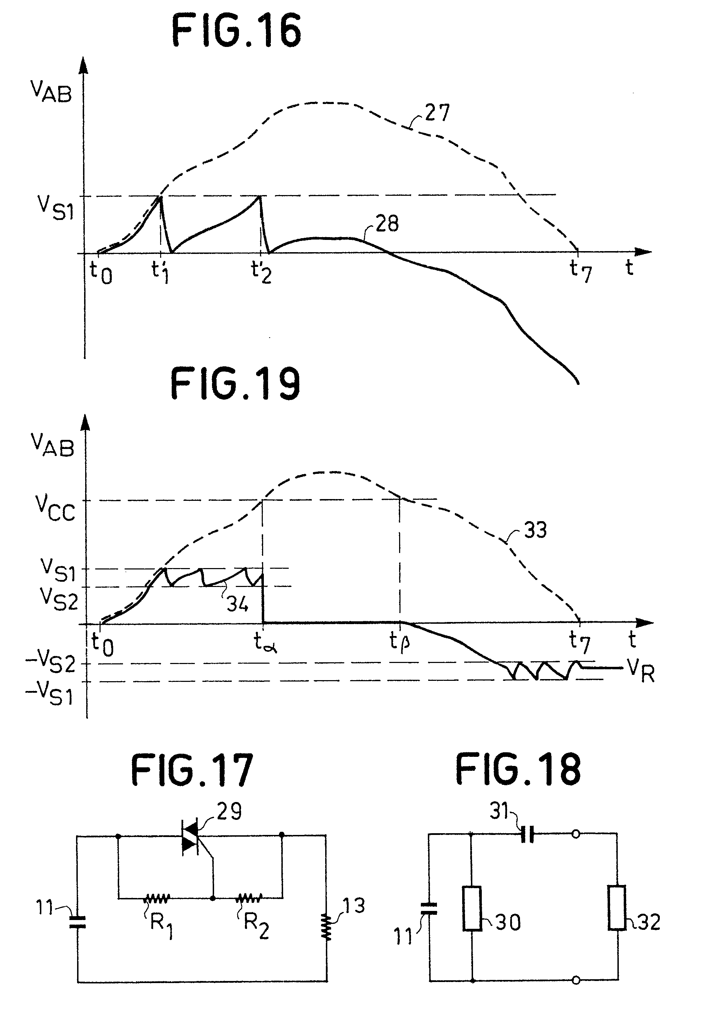

La figure 15 représente un circuit selon l'invention et utilisant un thyristor 26 comme élément non linéaire. On a gardé le tranducteur défini précédemment et figuré par une capacité 11 ainsi que la charge résistante 13. Les résistances $R_1$ et $R_2$ vont déterminer la valeur du courant de gâchette. Elles forment un pont diviseur de tension et en choisissant correctement leurs valeurs, on fixera la tension de seuil de conduction $V_{S1}$. Lorsque, à la suite d'une déformation, une tension apparaît entre les électrodes A et B du transducteur telle que $V_{AB} > 0$, le circuit reste ouvert, si on néglige le courant de fuite du thyristor, jusqu'à la tension de seuil $V_{S1}$ provoquant l'amorçage du thyristor. Une fois amorcé, le thyristor reste conducteur jusqu'à ce que la tension entre anode et cathode soit pratiquement nulle. Il s'ensuit que le nombre d'impulsions délivrées à la charge 13 en utilisant un thyristor est plus petit que lorsque le circuit comporte une lampe néon comme élément non linéaire. C'est ce que démontre la figure 16 qui représente en fonction du temps l'allure de la tension $V_{AB}$ aux bornes des électrodes du transducteur. On a volontairement choisi une déflexion de l'extrémité du transducteur identique à tout point de vue à celle qui a donné lieu à l'apparition des charges liées internes au transducteur dans le cas étudié précédemment, ce nombre de charges étant représenté par la courbe 15 de la figure 7. Sur la figure 16, la courbe 27 représente la tension $V_{AB}$ qui existerait si le circuit était ouvert en permanence. La tension de seuil $V_{S1}$ a été choisie identique à celle de l'expérience précédente. En supposant que, lorsque le thyristor n'est pas conducteur, le courant traversant la charge 13 et les résistances $R_1$ et $R_2$ ne contribue pas à une diminution sensible des charges disponibles, on obtient une tension $V_{AB}$ représentée par la courbe 28. Cette courbe montre qu'il n'y a que 2 impulsions (aux instants $t'_1$ et $t'_2$) fournies à la charge. Il est nécessaire également de prévoir un dispositif du genre de celui représenté aux figures 12 et 13 afin d'éliminer la tension résiduelle sur les électrodes du transducteur. Le circuit de la figure 15 ne délivre que des impulsions de même signe. En remplaçant le thyristor par un triac, il est possible d'obtenir des impulsions de signes opposés. Un tel montage est représenté à la figure 17. Sur cette figure le triac 29 est commandé comme précédemment par un pont diviseur de tension formé des résistances $R_1$ et $R_2$.

L'inconvénient des dispositifs à semi-conducteurs est que leur conductivité à l'état non conducteur n'est pas nulle : les courants de fuite sont rarement inférieurs au nanoampère, ce qui correspond pratiquement à une constante de temps de décharge du transducteur d'environ 1 seconde. Il est alors nécessaire d'actionner le transducteur dans un laps de temps beaucoup plus court (de 0,1 à 0,2 seconde) pour que l'effet de cette conductivité soit négligeable. Dans la pratique, c'est en fonction de cette conductivité parasite que devront être choisies les durées d'actions mécaniques et les charges libérées.

On peut envisager de monter l'élément non linéaire directement aux bornes du transducteur comme l'indique la figure 18. Aux bornes de l'élément non linéaire 30 qui peut être l'une des éléments décrits précédemment est branchée la charge 32 par l'intermédiaire du condensateur 31. La capacité du condensateur 31 peut être très inférieure à la capacité du transducteur si l'on ne désire transmettre que les fronts des impulsions à la charge 32.

Dans le cas où l'on utilise un élément non linéaire conduisant dans les deux sens comme un tube à néon, on constate (voir figure 9), qu'il y a disproportion entre le nombre d'impulsions positives et le nombre d'impulsions négatives. On peut tenter d'y remédier en provoquant un court-circuit entre les électrodes du transducteur lorsque la déflexion atteint une certaine valeur. C'est une remise à zéro des charges disponibles. La figure 19 représente l'évolution de la tension $V_{AB}$ entre les extrémités des électrodes du transducteur en fonction du temps. On a repris la même déflexion que celle qui a donné lieu à l'évolution de la tension $V_{AB}$ de la figure 8, pour le même circuit. La courbe 33 représente l'évolution de la tension $V_{AB}$ en circuit ouvert si aucun court-circuit n'était appliqué entre les électrodes A et B. Si la remise à zéro des charges se fait à partir d'une déflexion donnant lieu à une tension en circuit ouvert $V_{AB} = V_{CC}$, la courbe 34 représentant la tension $V_{AB}$ effective évoluera de $t_o$ à $t_\alpha$ de façon identique à la courbe 17 de la figure 8. A partir de $t_\alpha$ et jusqu'à $t_\beta$ un court-circuit annule la quantité de charges disponibles. De $t_\beta$ à $t_7$, instant où le transducteur revient à sa position initiale, la courbe 34 reprend son évolution avec des décharges lorsque $V_{AB}$ atteint la valeur $-V_{S1}$. On constate que dans le cas décrit le nombre des impulsions positives est égal au nombre des impulsions négatives. Ceci n'est pas vrai dans tous les cas de figure et dépendra en fait de l'allure de la déformation exercée sur le transducteur. La remise à zéro des charges tend à symétriser le système.

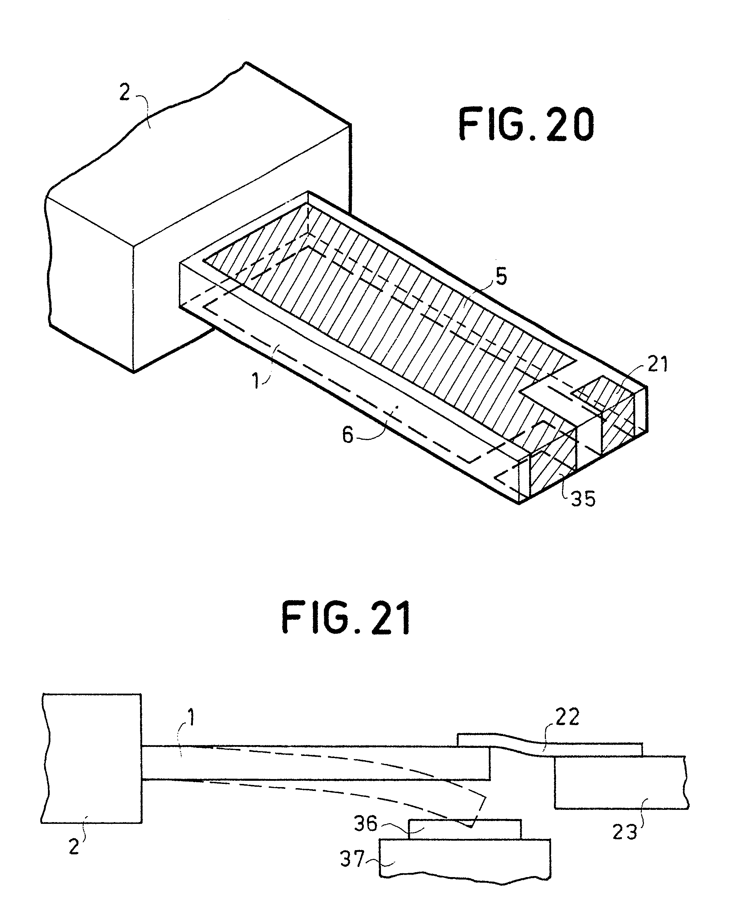

Le court-circuit peut être réalisé par un moyen identique à celui décrit aux figures 12 et 13. C'est ce que représentent les figures 20 et 21. Sur la figure 20, on remarque qu'une languette conductrice 35 poursuit l'électrode 5 sur la face opposée à l'emplacement d'une découpe effectuée dans l'électrode 6. Sur la figure 21, on a représenté en traits interrompus le transducteur 1 pour une déflexion maximale. Un socle fixe 37 supporte un élément 36 compressible qui amortit le tranducteur dans sa flexion maximale. Cet élément 36 doit être suffisamment conducteur pour décharger les électrodes. Il peut être par exemple réalisé en caoutchouc conducteur.

Le transducteur piézoélectrique peut être soumis à un effort progressif par l'appui sur une touche qui engendre une contrainte normale, une contrainte de cisaillement ou un contrainte de flexion. La touche peut provoquer un effet de gachette. Une flexion peut être imposée à un élément bimorphe par un appui progressif ou percussionnel sur une touche. L'avantage du bimorphe sur le homomorphe est que dans le cas où le matériau constitutif est pyroélectrique, le bimorphe à l'encontre du homomorphe n'engendre pas de charges dues à une variation de température homogène.

On peut envisager de limiter la tension disponible entre les électrodes par un élément provoquant un court-circuit entre ces électrodes à partir d'une certaine tension. On peut pour cela brancher en parallèle sur le transducteur un élément du genre diac ou thyristor. On peut également tailler la surface des électrodes de façon que, pour une déflexion maximale possible, n'avoir qu'une charge n'excédant pas une valeur désirée. Un autre moyen consiste à disposer d'un condensateur ajustable en parallèle sur le transducteur, ce condensateur étant ajusté pour une déflexion maximale possible du transducteur.

Les bimorphes à polymères piézoélectriques sont particulièrement avantageux car ils peuvent être produits en continu, à faible coût, avec des possibilités de déflexion bien supérieures à celles des bimorphes céramiques : pour une géométrie donnée, les forces nécessaires pour une même déflexion sont 20 à 50 fois plus faibles que pour les bimorphes céramiques et les tensions engendrées environ 100 fois supérieures. Il est donc avantageux de les employer pour réaliser des touches douces (soft touch) et de les utiliser dans des claviers.

Par souci d'économie des connexions et des moyens électroniques de traitement de données, les informations issues de la commande des touches d'un clavier sont généralement traitées sous forme matricielle. L'intersection d'une ligne et d'une colonne de la matrice détermine par la présence d'un signal l'action sur l'une des touches du clavier. Ce signal peut résulter du passage d'un courant dans une charge branchée à l'intersection de cette ligne et de cette colonne. Les circuits de traitement de données nécessitent généralement que les signaux de commande aient une référence, par

0083528

exemple la masse, il convient de disposer de deux charges symétriquement par rapport à la masse.

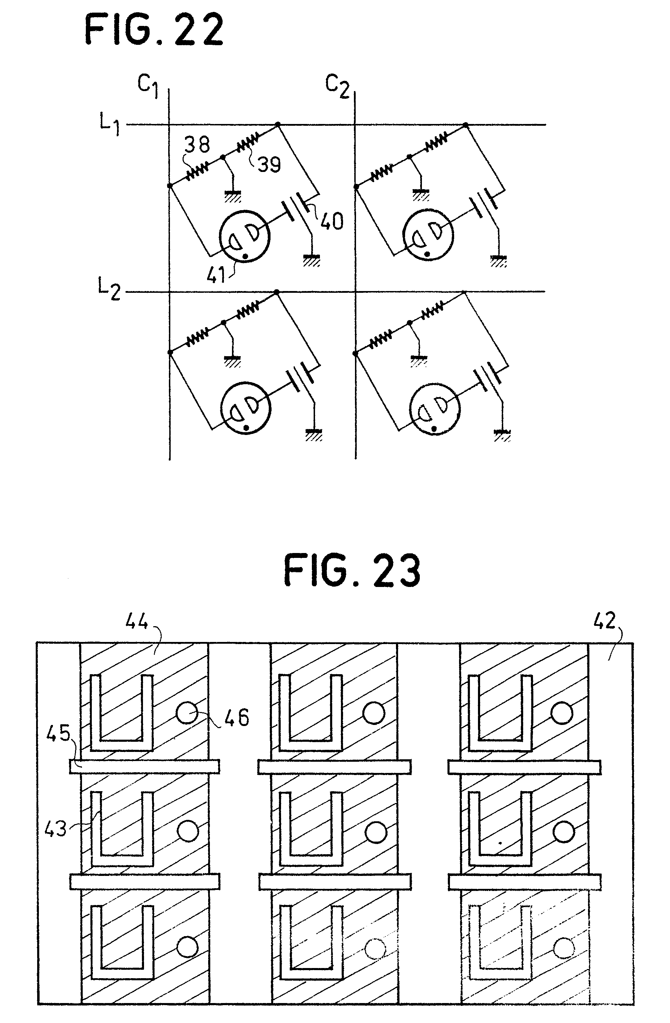

La figure 22 est un schéma électrique d'un clavier dont les touches sont constituées par des tranducteurs piézolélectriques bimorphes auxquelles sont associés des générateurs d'impulsions électriques selon l'invention. Par souci de clarté, on a représenté sur la figure 22 un système matriciel ne comportant que deux lignes $L_1$ et $L_2$ et deux colonnes $C_1$ et $C_2$ mais il peut en comporter beaucoup plus. Pour les raisons explicitées ci-dessus la charge est répartie en deux éléments, par exemple deux résistances 38 et 39, de valeur égale ayant leur point commun à la masse. Des résistances d'environ 10 k $\Omega$ conviennent très bien. Le bimorphe piézoélectrique 40 a son électrode centrale réunie à la masse. L'élément non linéaire 41 contribue à créer un générateur d'impulsions selon l'invention. On supposera que l'action sur une touche contribue effectivement à déclencher des impulsions dans les charges par un choix convenable des différentes composantes du circuit. Lorsqu'une touche a donc été actionnée des impulsions apparaissent dans les résistances de charge 38 et 39. Ces impulsions se retrouvent sur la ligne et la colonne correspondant à la touche actionnée et sont ensuite traitées par des circuits électroniques bien connus.

Dans ce cas, les éléments actifs bimorphes peuvent être découpés collectivement à l'emporte-pièce dans un socle unique, chacun d'eux étant constitué d'une lamelle mobile rectangulaire dont trois côtés sont découpés et dont le quatrième joue le rôle de charnière. Ces lamelles sont par conséquent assimilables à autant de modèles de poutre encastrée. Il est préférable d'implanter l'élément non linéaire et les charges propres à chaque générateur d'impulsions à proximité de chaque touche afin de limiter le plus possible la longueur des connexions. Celles-ci peuvent être réalisées sur les parties non découpées du clavier à la manière d'un circuit imprimé double face. Ces conducteurs peuvent être déposés par métallisation sous vide à l'aide de caches, ou gravés par attaque sélective de couches métalliques uniformes, ou encore déposés par sérigraphie. Il est particulièrement important d'assurer le meilleur isolement possible à la portion de circuit comprenant la face du bimorphe reliée à l'élément non linéaire du fait de la haute impédance d'entrée de l'élément non linéaire à l'état bloqué. Cette partie du circuit peut être facilement prévue sur une même face du clavier. Le risque d'isolement insuffisant provient surtout de la conductivité de surface qui est fonction en général du degré hygrométrique de l'air ambiant et de la concentration en poussières. Il est avantageux alors de passiver la face du clavier supportant l'élément non linéaire. Cette passivation peut être obtenue par dépôt d'une couche de polymère isolant en solution ou couchage d'un film de polymère adhésif.

D'après le schéma de principe de la figure 22 on voit que l'électrode centrale de chaque transducteur est réunie à la masse. Cette électrode pourrait servir de liaison de masse commune entre chaque transducteur mais pratiquement à cause du manque d'uniformité de l'épaisseur du socle il est préférable d'individualiser les électrodes centrales de chaque transducteur et de les relier à un conducteur de masse supporté par l'une ou l'autre face du socle. Dans cette hypothèse, on peut concevoir la réalisation de l'électrode centrale sous forme de bandes parallèles distribuées longitudinalement ou verticalement comme le montre la figure 23 qui est une vue de dessus d'un socle auquel on a retiré la lame supérieure pour ne laisser visible que l'électrode centrale sur la lame inférieure. Sur la lame piézoélectrique 42 servant de substrat, on distingue des touches 43 découpées à l'emporte-pièce et des bandes conductrices 44 disposées parallèlement entre elles. Des fentes 45 réalisées à l'emporte-pièce contribuent à isoler électriquement les électrodes internes les unes des autres. Des trous métallisés 46 permettent de relier chacune des électrodes internes avec un conducteur de masse situé sur l'une des faces du socle. La figure 23 donne l'exemple d'une réalisation possible pour un clavier de téléphone comprenant 9 touches.

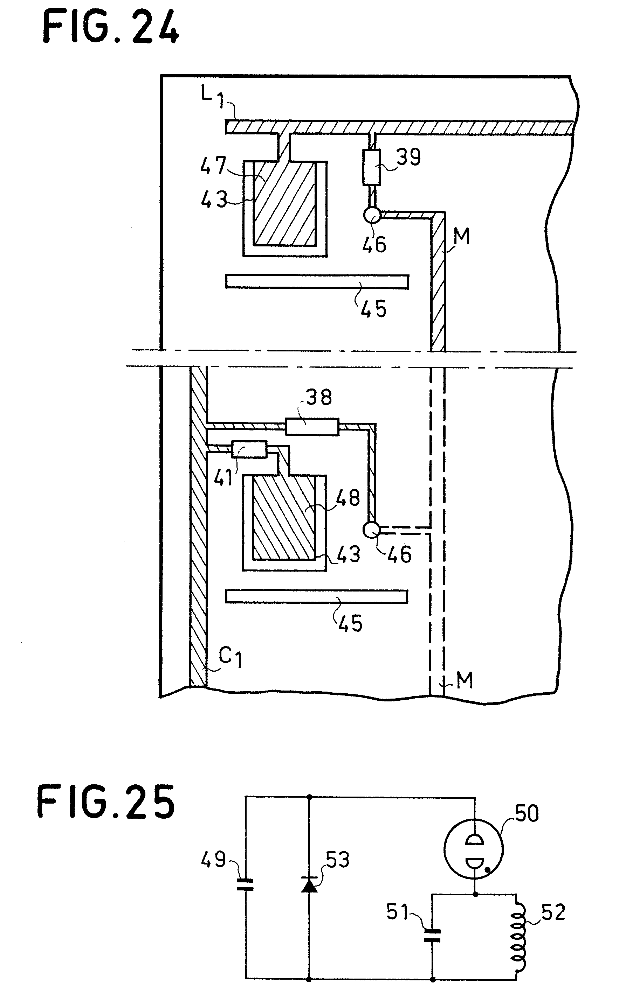

La figure 24 est une vue du câblage possible pour un tel clavier. Les connexions et les éléments des différents circuits peuvent être disposés sur chaque face du clavier. Deux touches seulement d'un clavier identique à celui de la figure 23 ont été représentées. La partie supérieure de la figure ne représente que les connexions et les éléments situés sur la face arrière du clavier comme si celui-ci était transparent. La partie inférieure de la figure représente les connexions et les éléments situés sur l'autre face qui eux sont visibles. La partie supérieure de la figure 24 révèle donc l'électrode 47 située sous la touche 43. Elle est reliée à la connexion de la ligne $L_1$ et à la charge 39 selon le schéma de la figure 22. L'autre extrémité de la charge 39 est réunie à la masse M. Toutes les métallisations de cette face ont été représentées hachurées. La partie inférieure de la figure 24 révèle l'électrode 48 située sur la touche 43, l'élément non linéaire 41 réunissant l'électrode 48 à la connexion de la colonne $C_1$ et la charge 38. Toutes les métallisations de cette face du clavier ont été représentées hachurées. On a figuré en traits interrompus la connexion de masse M située sur l'autre face.

Les touches du clavier peuvent être des touches à gachettes qui donnent la sensation d'avoir à dépasser un point dur pour agir effectivement sur la touche, ou des touches à simple enfoncement. On peut créer un rappel sonore indiquant l'enfoncement correct d'une touche, c'est-à-dire donnant lieu à au moins une impulsion, à l'aide de vibrateurs. Ceux-ci peuvent être constitués par des languettes bimorphes découpées dans une partie libre du circuit et excitées à leurs fréquences de résonance. Dans le cas où les éléments non linéaires sont des lampes néon, celles-ci peuvent être rendues apparentes sur le clavier et servir de témoin visuel d'action sur la touche.

On peut chercher à coder les touches du clavier de façon à diminuer le nombre des fils de sortie dans lesquels circulent des signaux codés. Ces signaux doivent en effet être reconnaissables par le circuit de traitement associé au clavier comme caractéristiques de l'enfoncement d'une touche donnée. Une première façon de coder les impulsions consiste à utiliser les impulsions positives pour un premier groupe de touches, les négatives pour un second groupe et les impulsions des deux signes pour un troisième. Une seconde façon de coder consiste à assigner aux impulsions produites par chaque touche des amplitudes priviligiées, par exemple en imposant aux différents générateurs des résistances de charges différentes ou des plages de conduction de l'élément non linéaire spécifiques à chaque générateur. Une troisième façon de coder consiste à différencier le nombre d'impulsions pour chaque générateur, par exemple en donnant à chaque transducteur des formes géométriques particulières.

Une application particulière de l'invention concerne les générateurs musicaux. Un générateur de note est représenté à la figure 25. Il comprend un transducteur piézoélectrique 49, un élément non linéaire 50, par exemple un tube à néon, un circuit résonant servant de charge et constitué par un condensateur 51 et une inductance 52. Le circuit résonant est un circuit LC parallèle accordée sur la fréquence de la note désirée. Lorsque, à la suite d'une action sur le transducteur 49, l'élément non linéaire 50 devient conducteur, un courant traverse le condensateur 51 qui se charge. A partir d'une certaine valeur de la tension aux bornes de ce condensateur l'extinction de l'élément 50 intervient. L'énergie électrostatique accumulée dans le condensateur et l'énergie magnétique stockée dans l'inductance assurent alors la résonance du circuit LC et une oscillation amortie apparaît aux bornes du circuit résonant, ce qui simule la décroissance de la note après son attaque. Une caractéristique particulière de ce générateur de note est que, au cas où la déformation du transducteur 49 génère plusieurs impulsions, les impulsions suivant la première sont en partie synchronisées sur celle-ci. En effet, l'élément 50 devient conducteur à partir du moment où la tension aux bornes du circuit LC a suffisamment chuté pour ne plus s'opposer valablement à la tension générée par le transducteur. La différence de potentiel aux bornes de l'élément 50 deviendra maximum au premier minimum de la tension aux bornes du circuit oscillant. Une diode 53 est placée en parallèle sur le transducteur, comme l'indique la figure 25, pour n'obtenir des signaux qu'à l'enfoncement de la touche. On obtient ainsi une caractéristique très recherchée des instrumentistes qui souhaitent que l'amplitude et/ou la couleur de la note dépende de la force et/ou de la vitesse de frappe sur la touche. Le circuit résonant peut également fonctionner comme émetteur radioélectrique pour réaliser par exemple une commande à distance.

Les générateurs piézoélectriques d'impulsions peuvent donc trouver des applications multiples. Ce sont des circuits fiables qui ne nécessitent pas d'apport extérieur d'énergie électrique ce qui est un grand avantage.

## REVENDICATIONS

1. Générateur d'impulsions électriques à commande mécanique comprenant au moins un transducteur piézoélectrique (11) muni d'une paire d'électrodes (5 et 6), caractérisé en ce qu'il comprend au moins un élément de commutation (12) entrant en conduction à partir d'un seuil et possédant une plage de conduction s'étendant en deçà dudit seuil, un circuit électrique d'utilisation (13) formant avec ledit élément et ledit transducteur un circuit à décharge brusque produisant l'une desdites impulsions lors d'un dépassement dudit seuil.

2. Générateur d'impulsions électriques selon la revendication 1, caractérisé en ce que ledit transducteur est un transducteur piézoélectrique bimorphe.

3. Générateur d'impulsions électriques selon l'une des revendications 1 ou 2, caractérisé en ce que ledit transducteur est un transducteur piézoélectrique polymère.

4. Générateur d'impulsions électriques selon l'une quelconque des revendications 1 à 3, caractérisé en ce que ledit élément de commutation est un tube à décharge gazeuse.

5. Générateur d'impulsions électriques selon la revendication 4, caractérisé en ce que ledit tube à décharge gazeuse est un tube à néon.

6. Générateur d'impulsions électriques selon l'une quelconque des revendications 1 à 3, caractérisé en ce que ledit élément de commutation est un dispositif à semi-conducteur (26) ayant deux états stables.

7. Générateur d'impulsions électriques selon l'un quelconque des revendications 1 à 6, caractérisé en ce que ledit élément de commutation et ladite charge sont branchés en série aux bornes du transducteur.

8. Générateur d'impulsions électriques selon l'une quelconque des revendications 1 à 7, caractérisé en ce que des moyens d'ajustement de la tension recueillie entre lesdites électrodes sont prévus.

9. Générateur d'impulsions électriques selon la revendication 8, caractérisé en ce que lesdits moyens d'ajustement consistent en la taille desdites électrodes.

10. Générateur d'impulsions électriques selon la revendication 8, caractérisé en ce que lesdits moyens d'ajustement consistent en l'ajustement d'un condensateur branché en parallèle sur ledit transducteur.

11. Générateur d'impulsions électriques selon la revendication 8, caractérisé en ce que lesdits moyens d'ajustement comprennent un élément limiteur de tension.

12. Générateur d'impulsions électriques selon la revendication 8 caractérisé en ce que des moyens auxiliaires de décharge sont prévus entre lesdites électrodes afin de créer au moins un court-circuit.

13. Générateur d'impulsions électriques selon l'une quelconque des revendications 1 à 11, caractérisé en ce qu'il comprend plusieurs transducteurs agencés en clavier.

14. Générateur d'impulsions électriques selon la revendication 12, caractérisé en ce que ledit clavier est formé à partir d'une structure monolithique où des languettes ont été découpées jouant le rôle de transducteurs piézoélectriques élémentaires.

15. Générateur d'impulsions électriques selon l'une quelconque des revendications 1 à 13, caractérisé en ce qu'il est prévu des moyens de contrôle de la bonne manipulation desdits transducteurs.

16. Générateur d'impulsions électriques selon l'une des revendications 1 à 6, caractérisé en ce que le circuit d'utilisation comprend un circuit électrique oscillant.

# FIG.1

FIG.2

FIG.3

FIG.4

# FIG.5

# FIG.6

0083528

4/10

FIG.7

FIG.8

FIG.9

FIG.10

FIG.11

FIG.12

## FIG.13

## FIG.14

## FIG.15

0083528

**FIG.16**

**FIG.19**

**FIG.17**

**FIG.18**

FIG. 20

FIG. 21

# FIG. 22

# FIG. 23

# FIG.24

$L_1$

47
43
39
46
M
45

38
41
48
43
46
45
$C_1$
M

# FIG.25

49
53
50
51
52

Office européen
des brevets

**RAPPORT DE RECHERCHE EUROPEENNE**

Numéro de la demande

EP 82 40 2347

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 455 818 (LEWINER et al.) <br> * Page 4, ligne 23 - page 7, ligne 9; figure 1 * | 1 | H 03 K 17/96 |
| A | DE-A-2 317 221 (LICENTIA) <br> * Page 8, dernier alinéa - page 9, ligne 9; figures 9,10 * | 1 | |

|  | DOMAINES TECHNIQUES RECHERCHES (Int. Cl. ³) |
|---|---|
|  | H 03 K |

Le présent rapport de recherche a été établi pour toutes les revendications

| Lieu de la recherche <br> LA HAYE | Date d'achèvement de la recherche <br> 07-04-1983 | Examinateur <br> CANTARELLI R.J.H. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82